(19) Europäisches Patentamt
European Patent Office
Office européen des brevets

(11) Publication number: **0 492 160 A1**

## (12) EUROPEAN PATENT APPLICATION

(21) Application number: **91120144.0**

(51) Int. Cl.$^5$: **C23C 16/26**

(22) Date of filing: **26.11.91**

(30) Priority: **20.12.90 US 630701**

(43) Date of publication of application:
**01.07.92 Bulletin 92/27**

(84) Designated Contracting States:
**DE FR GB SE**

(71) Applicant: **GENERAL ELECTRIC COMPANY**
**1 River Road**
**Schenectady New York 12305(US)**

(72) Inventor: **Anthony, Thomas Richard**
**2142 Lynnwood Drive**
**Schenectady, New York 12309(US)**
Inventor: **Fleischer, James Fulton**
**4 Woodside Drive**
**Scotia, New York 12302(US)**

(74) Representative: **Pratt, Richard Wilson et al**
**London Patent Operation G.E. Technical Services Co. Inc. Essex House 12/13 Essex Street**
**London WC2R 3AA(GB)**

## (54) Symmetric CVD diamond articles and method of their preparation.

(57) The present invention is directed to a method for the chemical vapor depositon (CVD) of a layer of diamond on a substrate held at elevated CVD diamond-forming temperature wherein a hydrocarbon gaseous mixtures is passed over a hot elongate filament for at least partially decomposing said mixture to form said CVD diamond layer on said substrate. The present invention specifically is directed to forming a substantially uniformly thick CVD diamond layer on the substrate which is stationary. Such method comprises disposing said substrate stationarily at a distance, C, from a hot elongate filament. The substrate has a maximum radius, R, which is defined as the maximum distance from the center of the substrate to an outermost surface to be coated by the layer of CVD diamond. The substrate also is disposed parallel about its axis to the filament. The layer of CVD diamond becomes more uniform in thickness as the ratio, R/C, decreases. An advantageous substrate is a wire which can be coated with a layer of CVD diamond for making a nozzle, wire drawing, die, or other annular article when the wire is separated from the resulting diamond annulus. For a wire substrate and two hot filaments, ratios of r/c of less than about 0.05 provide substantially uniform CVD diamond layers on the wire substrate. For a wire substrate and a single filament, ratios of r/c of less than about 0.02 also provide substantially uniform CVD diamond layers.

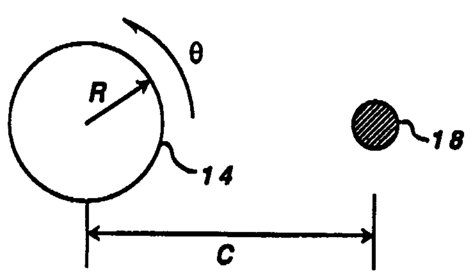


Fig. 3

EP 0 492 160 A1

## Background of the Invention

The present invention relates to diamond workpieces and more particularly to their fabrication based on chemical vapor deposition technology.

Its hardness and thermal properties are but two of the characteristics that made diamond useful in a variety of industrial components. Initially, natural diamond was used in a variety of abrasive applications. With the ability to synthesize diamond by high pressure/high temperature (HP/HT) techniques utilizing a catalyst/sintering aid under conditions where diamond is the thermally stable carbon phase, a variety of additional products found favor in the marketplace. Polycrystalline diamond compacts, often supported on a tungsten carbide support in cylindrical or annular form, extended the product line for diamond additionally. However, the requirement of high pressure and high temperature has been a limitation, for example, in product configuration.

Recently, industrial effort directed toward the growth of diamond at low pressures, where it is metastable, has increased dramatically. Although the ability to produce diamond by low-pressure synthesis techniques has been known for decades, drawbacks including extremely low growth rates prevented wide commercial acceptance. Recent developments have led to higher growth rates, thus spurring recent industrial interest in the field. Additionally, the discovery of an entirely new class of solids, known as "diamondlike" carbons and hydrocarbons, is an outgrowth of such recent work.

Low pressure growth of diamond has been dubbed "chemical vapor deposition" or "CVD" in the field. Two predominant CVD techniques have found favor in the literature. One of these techniques involves the use of a dilute mixture of hydrocarbon gas (typically methane) and hydrogen wherein the hydrocarbon content usually is varied from about 0.1% to 2.5% of the total volumetric flow. The gas is introduced via a quartz tube located just above a hot tungsten filament which is electrically heated to a temperature ranging from between bout 1750° and 2400°C. The gas mixture disassociates at the filament surface and diamonds are condensed onto a heated substrate placed just below the hot tungsten filament. The substrate is held in a resistance heated boat (often molybdenum) and heated to a temperature in the region of about 500° to 1100°C.

The second technique involves the imposition of a plasma discharge to the foregoing filament process. The plasma discharge serves to increase the nucleation density, growth rate, and it is believed to enhance formation of diamond films as opposed to discrete diamond particles. Of the plasma systems that have been utilized in this area, there are three basic systems. One is a microwave plasma system, the second is an RF (inductively or capacitively coupled) plasma system, and the third is a d.c. plasma system. The RF and microwave plasma systems utilize relatively complex and expensive equipment which usually requires complex tuning or matching networks to electrically couple electrical energy to the generated plasma. Additionally, the diamond growth rate offered by these two systems can be quite modest.

Symmetrical diamond coating of an object with the hot filament CVD diamond technique can be accomplished by rotating the object about an axis parallel to the filament during deposition. However, in some instances, substrate rotation can be a source of other problems. Rotating the substrate generates periodic temperature fluctuations of the surface of the object as it passes from its own day-to-night-to-day cycle. Also, rotation of the substrate requires special vacuum feed-throughs, motors, and substrate mounts. Such accessories are expensive, liable to break-downs, and complicate heating of the substrate by direct resistive means.

## Broad Statement of the Invention

The present invention is directed to a method for the chemical vapor deposition (CVD) of a layer of diamond on a substrate held at elevated CVD diamond-forming temperature wherein a hydrocarbon gaseous mixture is passed over a hot elongate filament for at least partially decomposing said mixture to form said CVD diamond layer on said substrate. The present invention specifically is directed to forming a substantially uniformly thick CVD diamond layer on the substrate which is stationary. Such method comprises disposing said substrate stationarily at a distance, C, from a hot elongate filament. The substrate has a maximum radius, R, which is defined as the maximum distance from the center of the substrate to an outermost surface to be coated by the layer of CVD diamond. The substrate also is disposed parallel about its axis to the filament. The layer of CVD diamond becomes more uniform in thickness as the ratio, R/C, decreases. An advantageous substrate is a wire which can be coated with a layer of CVD diamond for making a nozzle, wire drawing die, or other annular article when the wire is separated from the resulting diamond annulus. For a wire substrate and two hot filaments, ratios of R/C of less than about 0.05 provide substantially uniform CVD diamond layers on the wire substrate. For a wire substrate and a single filament,

ratios of R/C of less than about 0.02 also provide substantially uniform CVD diamond layers.

Advantages of the present invention include the ability to heat the substrate readily since it is stationary during the CVD deposition process. Another advantage is the ability to substantially uniformly coat substrates with either one or two filaments. Another advantage of the present invention is the minimization of thermal stresses suffered by the substrate and CVD diamond layer during deposition by dint of the rotation heretofore used in the art. These and other advantages will be readily apparent to those skilled in the art based upon the disclosure contained herein.

## Brief Description of the Drawings

Fig. 1 is a schematic diagram of the two filament process with the substrate located between two filaments that are separated by a total distance 2C;

Fig. 2 is a schematic diagram of the deposit anisotropy resulting from the two-filament schematic diagram represented at Fig. 1;

Fig. 3 is a schematic diagram of the one filament process with the substrate located a distance, C, from the filament;

Fig. 4 is a schematic diagram of the deposit anisotropy for the single filament schematic diagram represented at Fig. 3; and

Fig. 5 is a simplified schematic diagram of a wire substrate coated with a layer of CVD diamond in accordance with the inventive process being cut with a laser.

The drawings will be described in detail in connection with the description that follows.

## Detailed Description of the Invention

Conventional high pressure/high temperature techniques utilized in the production of diamond crystals and polycrystalline diamond compacts necessarily are limited to configurations compatible with necessary high pressure utilization in their formation. Accordingly, cylindrical polycrystalline diamond compacts typically are produced and then machined (e.g. electrical discharge machining or the like) to an intermediate or final product configuration. Complex product shapes are difficult to produce by such techniques. Chemical vapor deposition techniques, however, are not so-limited since the diamond is grown/deposited from a gaseous mixture directly onto a heated substrate. The heated substrate can have virtually any shape since the gaseous mixture can be directed onto the entire substrate or just portions thereof.

Of course, deposition of CVD diamond onto complicated shapes has been proposed in the past; however, such proposals were forming a supported diamond product. The present invention employs a process analogous to conventional molding processes wherein a pattern or core substrate is used in shaping a product, which pattern or core optionally may be removed, through not necessarily. If the pattern upon which the CVD diamond layer is deposited/grown in the present invention is removed from the CVD diamond layer, a three-dimensional diamond workpiece of desired configuration is produced. If the substate is not removed, then a supported CVD diamond product results.

With respect to conventional CVD processes useful in the present invention, hydrocarbon/hydrogen gaseous mixtures are fed into a CVD reactor or chamber as an initial step. Hydrocarbon sources can include methane series gases, e.g. methane, ethane, propane; unsaturated hydrocarbons, e.g. ethylene, acetylene, cyclohexene, and benzene; and the like. Methane, however, is preferred. The molar ration of hydrocarbon to hydrogen broadly ranges from about 1:10 to about 1:1,000 with about 1:100 being preferred. This gaseous mixture optionally may be diluted with an inert gas, e.g. argon. The gaseous mixture is at least partially decomposed thermally using the hot filament technique. This technique involves the use of a hot filament which normally is formed of tungsten, molybdenum, tantalum, or alloys thereof. U.S. Pat.No. 4,707,384 illustrates this process. The substrate optionally may be bombarded with electrons during the CVD deposition process in accordance with U.S. Pat. No. 4,740,263.

The substrate is maintained at an elevated CVD-diamond forming which typically ranges from about 500° to 1100° C and preferably is in the range of about 850° to 950°C where diamond growth is at its highest rate in order to minimize grain size. Since the substrate is not rotated in the inventive process, an electric current can be passed through the substrate for maintaining the desired CVD-diamond forming temperature. Pressures in the range of from about 0.01 to 1,000 Torr, advantageously about 1-800 Torr, are taught in the art, with reduced pressure being preferred. Details on CVD processes additionally can be reviewed by reference to Angus, et al., "Low-Pressure, Metastable Growth of Diamond and 'Diamondlike' Phases", Science, vol. 241, pp 913-921 (Aug. 19, 1988); and Bachmann, et al., "Diamond Thin Films", Chemical Engineering News, pp. 24-39 (May 15, 1989), the disclosures of which are expressly incorporated

herein by reference.

With respect to the substrate, it will be appreciated that the materials of construction necessarily must be stable at the elevated CVD diamond-forming temperatures required by the CVD processing employed. Accordingly, appropriate materials include, for example, metals (e.g. tungsten, molybdenum, silicon, and platinum), alloys, ceramics (e.g. silicon carbide, boron nitride, aluminum nitride), glasses, ad carbon (e.g. graphite). Substrates of mixed composition also may be utilized as is necessary, desirable, or convenient. Thickness as thin as 1 micrometer on up to 2,000 micrometers or more can be laid down, depending upon processing conditions and most importantly upon time.

A theory has been developed to explain the substantially uniformly thick CVD diamond layers on stationary substrates achieved by the present invention. The following theoretical discussion is given with respect to the two filament case and the one filament case. With respect to the theory in the two filament case, the diffusion field during CVD diamond deposition satisfies Laplace's equation if one ignores the loss of active species between the filament and substrate. For present purposes, a wire substrate will be assumed for simplicity, though it is illustrative of other substrate configurations. Since the filaments and the substrate are long parallel wires, the following two-dimensional Laplace equation obtains:

$$\text{(I)} \qquad N(R,\theta) = N_0 \ln(\vec{R} - C\vec{i}) + N_0 \ln(\vec{R} + C\vec{i}) - 2 N_0 \ln(\vec{R})$$

In equation (I), $N(R,\theta)$ is a concentration of active diamond-depositing species in the reactor, R is the distance from the substrate center, $\theta$ is the angle about the substrate center, C is the filament-substrate separation distance, and i is the unit vector along the X axis. Fig. 1 is a schematic diagram of the two filament process with the substrate located between two-filaments that are separated by the distance 2C. Filaments 10 and 12, and substrate 14 are long wires that are parallel to each other.

The diffusion flux impinging on the substrate is given by the following equation:

$$\text{(II)} \qquad J(R,q) = -D \frac{dN}{dR} \qquad \frac{1}{|\vec{R} - C\vec{i}|} \qquad \frac{1}{|\vec{R} + C\vec{i}|} + \frac{2}{|\vec{R}|}$$

The growth rate of CVD diamond on the periphery of the substrate is given by the following equation:

$$\text{(III)} \qquad v = \frac{J(R,\theta)}{N_D}$$

where $N_d$ is the number of atoms per unit volume of carbon in diamond.

The aspect ratio, A/B (see Fig. 2), of deposited diamond layer 16 is given by the growth rate at $\theta = 0$, divided by the growth rate at $\theta = \pi/2$:

$$\text{(IV)} \qquad \frac{A}{B} = \frac{\frac{1}{(R-C)} + \frac{1}{(R+C)} - \frac{2}{R}}{\frac{2}{\sqrt{C^2 + R^2}} - \frac{2}{R}}$$

For the two filament case, the aspect ratio (A/B) is given in the following table versus the substrate radius, R, divided by the filament-substrate separation, C.

TABLE I

| R/C | A/B | Growth Rate |
|---|---|---|
| 0.5 | 2.4 | 1 |
| 0.2 | 1.29 | 2 |
| 0.1 | 1.12 | 4 |
| 0.05 | 1.05 | 10 |
| 0.02 | 1.02 | 20 |
| 0.01 | 1.01 | 40 |

It can be seen from the above-tabulated data, that the aspect of the diamond deposit approaches 1 (complete symmetry) as the substrate radius becomes a small fraction of the filament-substrate separation. For practical purposes, R/C ratios of less than about 0.05 provide substantially uniform coatings on the substrate.

For the one filament case, again assuming that the filament and substrate are long parallel wires, a two-dimensional Laplace equation again obtains:

$$(V) \qquad N(R,\theta) = N_0 \ln(\vec{R} - \vec{C}) - N_0 \ln(\vec{R})$$

Fig. 3 is a schematic diagram of the one-filament process with the substrate located a distance, C, from the filament. Again, filament 18 and substrate 14 are assumed to be long, parallel wires.

The diffusion flux impinging upon substrate 14 is given by the following equation:

$$(VI) \qquad J(R,\theta) = -D \frac{dN}{dR} = \frac{1}{|\vec{R} - \vec{C}|} - \frac{1}{|\vec{R}|}$$

The growth rate of CVD diamond on the periphery of the substrate is given by the following equation:

$$(VII) \qquad v = \frac{J(R,\theta)}{N_D}$$

where $N_D$ is a number of atoms per unit volume of carbon and diamond.

The aspect ratio, A/B (see Fig. 4), of deposited diamond layer 20 is given by the growth rate at $\theta = 0$ divided by the growth rate at $\theta = \pi/2$, as follows:

$$(VIII) \qquad \frac{A}{B} = \frac{\frac{1}{(R - C)} - \frac{1}{R}}{\frac{1}{\sqrt{C^2 + R^2}} - \frac{1}{R}}$$

For the one-filament case, the aspect ratio, A/B, is given in Table 2 versus the substrate radius, R, divided by the filament-substrate separation, C.

TABLE II

| R/C | A/B | Growth Rate |
|---|---|---|
| 0.1 | 1.22 | 2 |
| 0.05 | 1.10 | 4 |
| 0.02 | 1.04 | 10 |
| 0.01 | 1.02 | 20 |

It can be seen from the above-tabulated data that the aspect ratio of the diamond deposit approaches 1 (complete symmetry) as the substrate radius becomes a small fraction of the filament-substrate separation. For a similar geometry, however, the growth rate in the one filament case is one-half the growth rate of the two filament case, as expected.

In the one filament case, an equal concern to the aspect ratio, A/B, is the diamond deposition radius, A-($\theta$ = 0), on the substrate face side facing the filament versus the diamond deposition radius, A' ($\theta$ = $\pi$) on the substrate side opposite to the filament (see Fig. 4). The ratio of such side-facing and side-opposite layers can be expressed as follows:

$$\text{(IX)} \quad \left|\frac{A}{A'}\right| = \left|\frac{C+R}{C-R}\right|$$

The ratio of the side-facing and the side-opposite diamond layers as a function of the substrate radius, R, divided by the filament-substrate separation, C, is set forth in Table III below.

TABLE III

| R/C | A($\theta$ = 0)/A'($\theta$ = $\pi$) |
|---|---|
| 0.1 | 1.22 |
| 0.05 | 1.11 |
| 0.02 | 1.04 |
| 0.01 | 1.02 |

Again, one observes that when the filament-substrate separation, C, is much larger than the substrate radius, R, the deposition thickness on the side of the substrate facing and opposing the filament become equal, i.e. a substantially uniformly thick CVD diamond layer in the substrate results.

If the substrate were of more complicated geometry and not cross-sectionally uniform, the equations set forth above would be three-dimensional, though the same net solution would result, i.e. increasing the R/C ratio results in more uniformly thick CVD diamond layers on the substrate.

After CVD diamond deposition on a cylindrical mandrel, the mandrel-diamond can be cut into sections, e.g. using a Q switched Nd-YAG laser. Fig. 5 illustrates such cutting routine wherein molybdenum mandrel 22 is coated with CVD diamond layer 24 which is cut by laser 26. Of interest when making cylindrical tubes for use as water-jet mixing tubes, wire drawing dies, water-jet nozzles, or the like, is the characteristic bevel of the diamond layer which results utilizing the laser cutting technique. Such rough cut results in the inner lip or rim of the resulting CVD diamond layer protruding for the body of the diamond tube or annulus above the outer rim or edge thereof. When the molybdenum mandrel is removed, e.g by etching, one or both ends of the tube can be polished. One end of the water-jet nozzle must be polished since the ID edge of the high-pressure side of the nozzle is critical in forming a non-divergent water jet. Because of the rough shape of the laser-cut nozzle, the ID edge of the nozzle is the first part of the nozzle to polish when the nozzle is applied to a diamond polishing scaife. In fact, the ID edge of the cylinder is important when the hole penetrating the tube is to be used, such as for a water-jet nozzle, wire-drawing die, or the like. Fortuitously, the use of the laser cutting technique substantially reduces the time it takes to polish the ID edge of the resulting CVD diamond tube.

As stated above, it will be recognized that substrate configurations can be varied substantially in addition the cylindrical substrate or mandrel described herein, provided that the R/C ratio is held sufficiently

large that substantially uniform diamond layer results during the CVD deposition process. All citations herein are expressly incorporated by reference.

**Claims**

1. In a method for the chemical vapor deposition (CVD) of a layer of diamond on a substrate held at elevated CVD diamond-forming temperature wherein a hydrocarbon gaseous mixture is passed over a hot elongate filament for at least partially decomposing said mixture to form said CVD diamond layer on said substrate, the improvement for forming a substantially uniformly thick CVD diamond layer on said substrate which is stationary, which comprises:
   disposing said substrate stationarily at a distance, C, from a hot elongate filament, said substrate having a maximum radius, R, said substrate being disposed parallel to said filament, and
   decreasing the ratio, R/C, for said layer to become more uniform in thickness.

2. The method of claim 1 wherein a single hot elongate filament is used.

3. The method of claim 1 wherein a pair of hot filaments are spaced 2C apart.

4. The method of claim 2 wherein R/C is not above about 0.02.

5. The method of claim 3 wherein R/C is not above about 0.05.

6. The method of claim 1 wherein said substrate comprises an elongate wire.

7. The method of claim 1 wherein said substrate is removed from said layer of diamond following the deposition of said layer.

8. The method of claim 1 wherein said substrate is one or more of a metal, an alloy, a ceramic, or carbon.

9. The method of claim 8 wherein said substrate comprises Mo.

10. The method of claim 6 wherein the resulting annular diamond coated wire is cut into pieces with a laser.

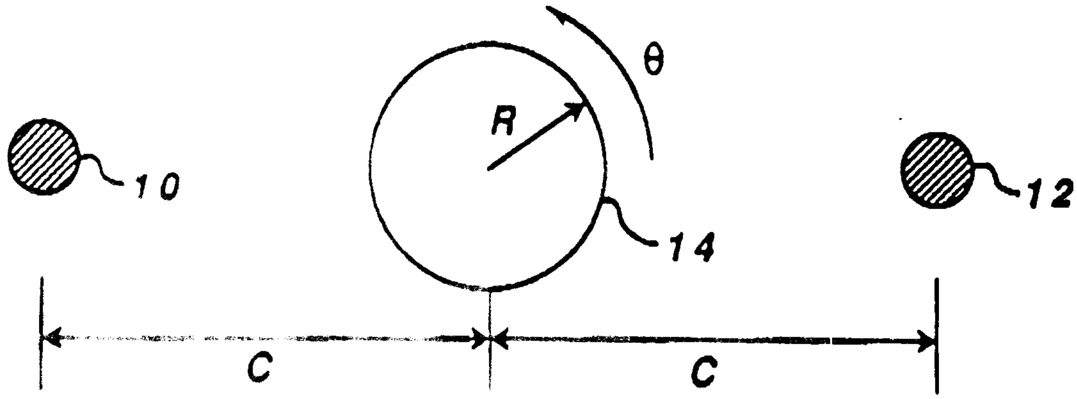


Fig. 1

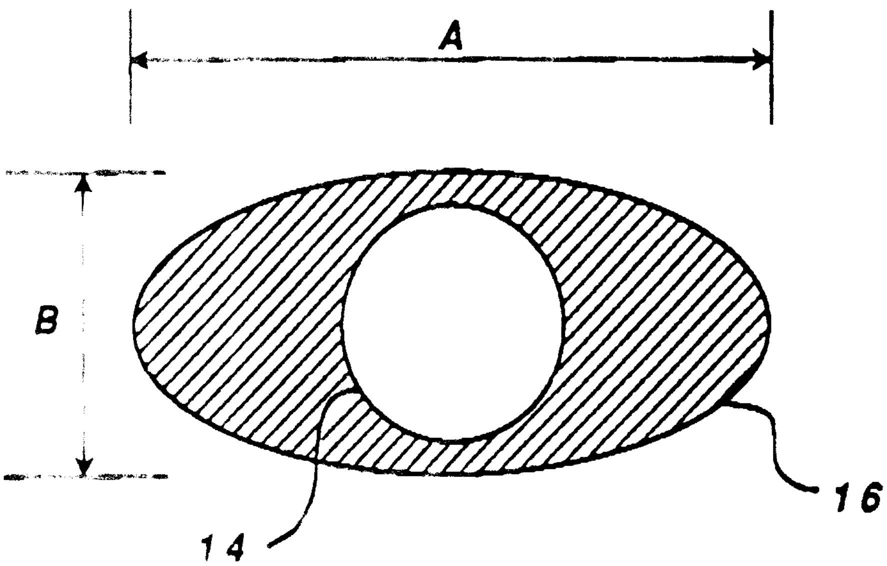


Fig. 2

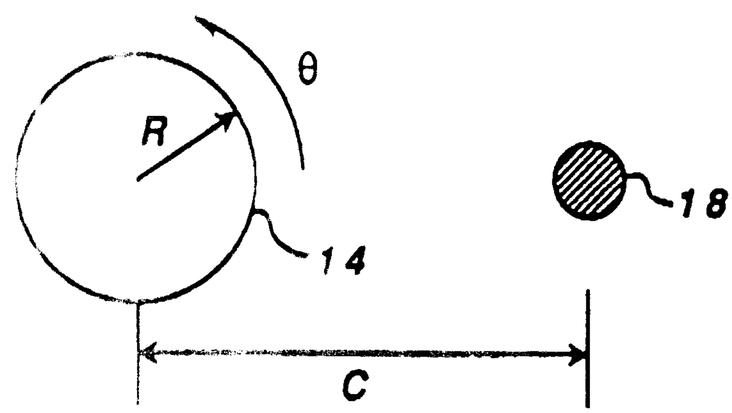


Fig. 3

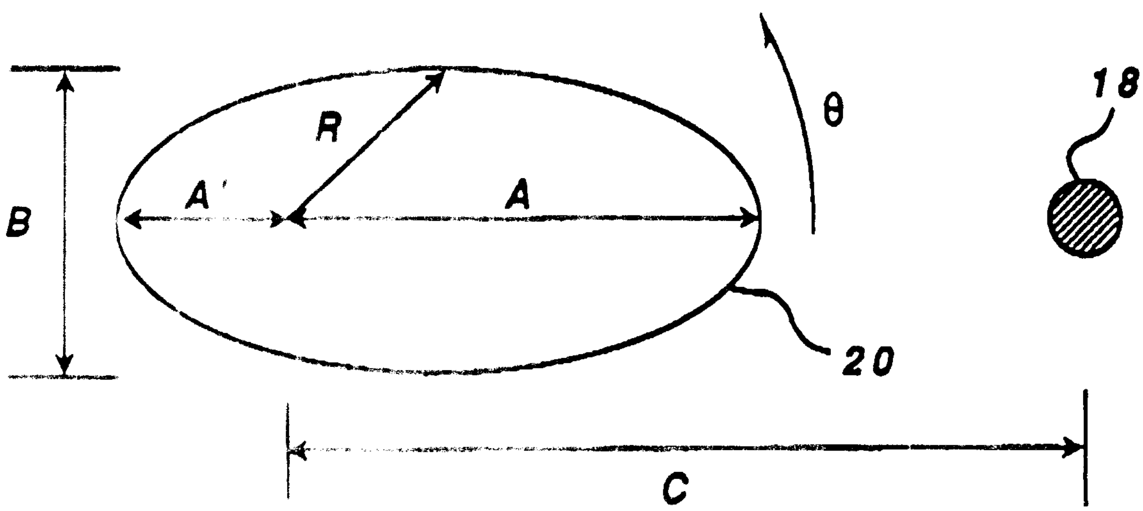


Fig. 4

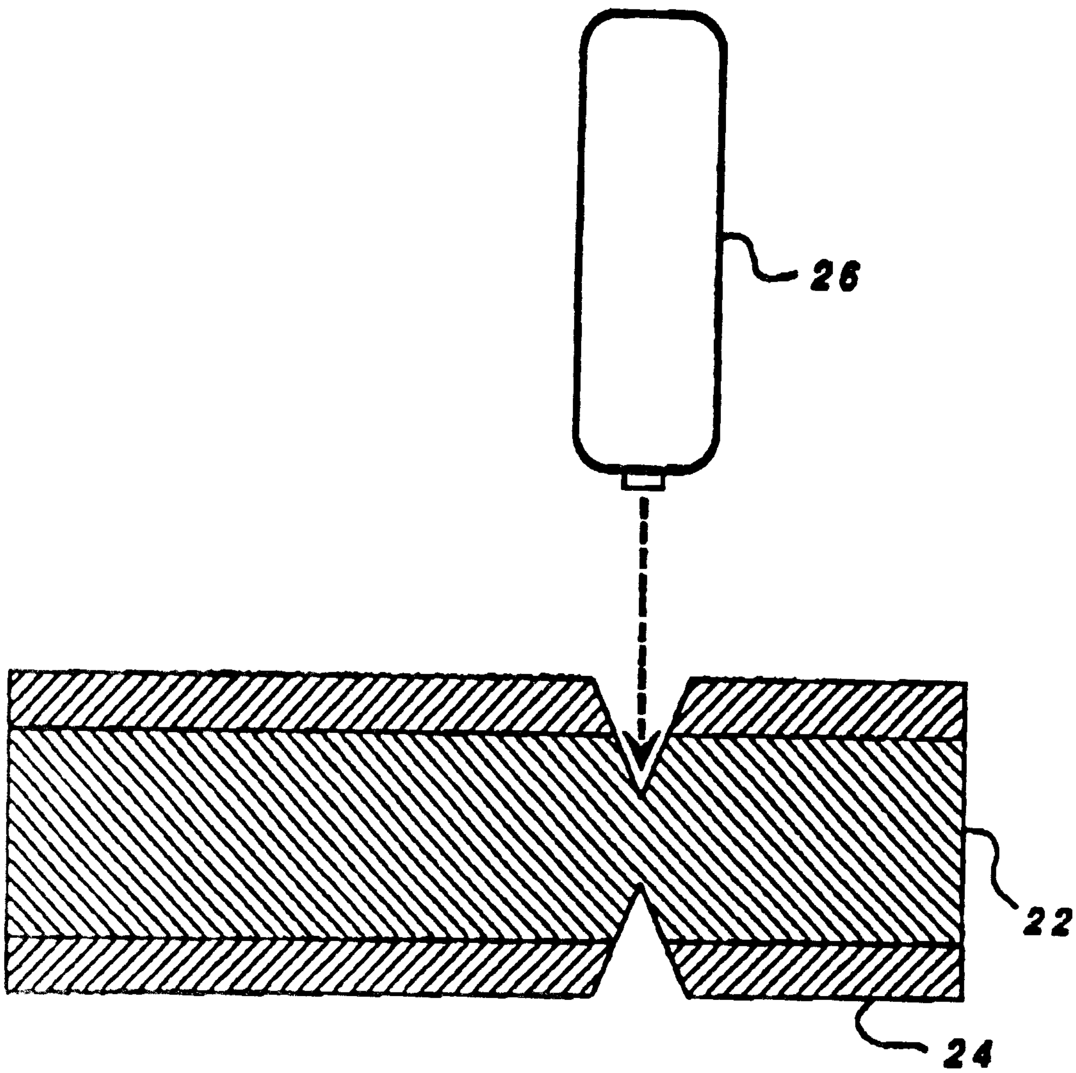


Fig. 5

European Patent Office

# EUROPEAN SEARCH REPORT

Application Number

EP 91 12 0144

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | EP-A-0 402 671 (GENERAL ELECTRIC COMPANY)<br>* column 6, line 39 - line 49; figure 1 *<br>* column 6, line 34 - line 48 *<br>--- | 1,2,7-10 | C23C16/26 |
| A | SPIE<br>vol. 1146, 1989, LONDON/GB<br>pages 208 - 216;<br>OBATA ET AL.: 'Free-standing diamond films - plates, tubes and curved diaphragms'<br>*Experimental section*<br>* figure 1 *<br>--- | 1,7 | |
| A | US-A-4 970 986 (ANTHONY ET AL.)<br>* claim 1 *<br>----- | 1,3 | |
| | | | **TECHNICAL FIELDS SEARCHED (Int. Cl.5 )** |
| | | | C23C<br>C30B |

The present search report has been drawn up for all claims

| Place of search | Date of completion of the search | Examiner |
|---|---|---|
| THE HAGUE | 30 MARCH 1992 | PATTERSON A.M. |

**CATEGORY OF CITED DOCUMENTS**

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)